(19) Europäisches Patentamt
European Patent Office
Office européen des brevets

(11) EP 0 837 558 A1

(12) **EUROPEAN PATENT APPLICATION**

(43) Date of publication:
**22.04.1998 Bulletin 1998/17**

(51) Int. Cl.[6]: **H03F 3/45**

(21) Application number: **97109138.4**

(22) Date of filing: **05.06.1997**

(84) Designated Contracting States:
**AT BE CH DE DK ES FI FR GB GR IE IT LI LU MC NL PT SE**
Designated Extension States:
**AL LT LV RO SI**

(30) Priority: **18.10.1996 US 733899**

(71) Applicant:
**Hewlett-Packard Company**
**Palo Alto, California 94304 (US)**

(72) Inventors:
- **Knee, Derek L.**
  **Fort Collins, CO 80525 (US)**
- **Moore, Charles E.**
  **Loveland, CO 80537 (US)**

(74) Representative:
**Schoppe, Fritz, Dipl.-Ing.**
**Schoppe & Zimmermann**
**Patentanwälte**
**Postfach 71 08 67**
**81458 München (DE)**

# (54) A CMOS op-amp input stage with constant small signal gain from rail-to-rail

(57) A CMOS constant transconductance operation amplifier input stage has a PMOS (104, 204) and a NMOS differential pair (102, 202). The gain from each differential pair is summed to provide the overall gain for the input stage. The gains from each individual differential pair when the other is not operating are chosen to be equal. At least one pair of sense transistors (106, 206, 280), coupled to the inputs (INN, INP), reduces the tail current of at least one of the differential pairs when those sense transistors are conducting. The amount of current the sense transistors conduct is chosen to equalize the transconductance of the input stage over a common mode input voltage range which runs from the negative supply voltage to the positive supply voltage.

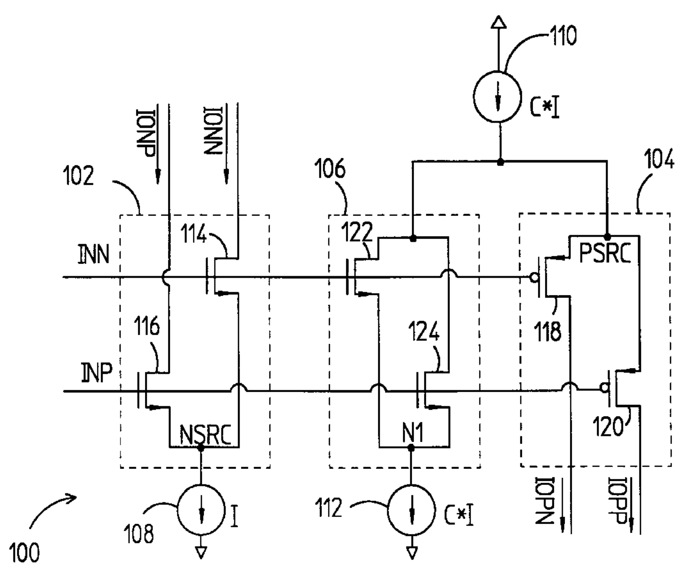


FIGURE 1

EP 0 837 558 A1

## Description

### Field of the Invention

This invention relates generally to operational amplifiers. More particularly, this invention relates to a CMOS amplifier with improved performance over an input range which varies from the negative supply voltage to the positive supply voltage. More particularly, this invention presents an input stage which provides a nearly constant small signal transconductance ($g_m$) over an input range which runs from supply voltage to supply voltage.

### Background of the Invention

Operational amplifiers (op-amps) are high gain, high input impedance, voltage amplifiers. These amplifiers generally amplify the voltage difference between two inputs. In a typical application, an op-amp is used in conjunction with a feedback circuit. The feedback circuit controls the operating characteristics of the op-amp/feedback system. Therefore, op-amps are used as general purpose building blocks in a wide variety of circuit designs.

Rail-to-rail op-amps are desirable because they maximize the common mode input range (CMIR). This factor is increasingly important as advancing integrated circuit (IC) process technologies reduce the nominal supply voltage to conserve power and increase speed. It is desirable for an op-amp to have a $g_m$ which is constant and independent of the common mode input voltage. To achieve a constant $g_m$ for the whole op-amp, an input stage which provides a constant $g_m$ is required. One major design parameter used in op-amp designs is the unity gain frequency. The unity gain frequency is used to determine the frequency response of the op-amp/feedback system. The unity gain frequency of the op-amp depends on the $g_m$ of the op-amp, and likewise, the $g_m$ of the input stage. Accordingly, to obtain optimal frequency compensation for the whole op-amp/feedback system over the range of possible common mode input voltages, the $g_m$ of the input stage must be constant over the range of possible common mode input voltages.

One shortcoming of prior art input stages which attempt to provide a constant $g_m$ over a rail-to-rail CMIR is that they require external reference voltages. This requirement adversely affects the amount of supply noise which is coupled into the input stage. Furthermore, these prior art circuits tend to be very complex. This complexity translates directly into increased physical circuit area, and increased cost.

Accordingly, there is a need in the art for an op-amp input stage which has a constant $g_m$ over the entire range of common mode input voltages. The $g_m$ of the input stage should be maximized so that the $g_m$ of the whole op-amp is maximized. There is a need in the art for an input stage which operates with the low supply voltages of modern integrated circuit fabrication technologies. There is a need in the art for an input stage which does not require external bias or reference voltages so that circuit complexity may be minimized and the coupling of supply noise into the input stage is minimized.

### SUMMARY OF THE INVENTION

This invention achieves a nearly constant $g_m$ over a rail-to-rail CMIR. Two differential pairs, one composed of enhancement mode field effect transistors with an n-type channel conductivity (NMOS) and one composed of enhancement mode field effect transistors with a p-type channel conductivity (PMOS), are driven by the same differential inputs. By using two differential pairs with opposite channel conductivity type (i.e. NMOS and PMOS) at least one of the differential pairs is operating for any common mode input voltage which is between the two supply rails. The $g_m$ of the input stage is the sum of the $g_m$ of these two differential pairs. The $g_m$ of each differential pair depends on the tail current through the differential pair. When the common mode input voltage is near a supply voltage, one of the differential pairs begins to turn off. This changes the tail current that flows through the differential pair which, in turn, changes the $g_m$ of that differential pair. Because each individual differential pair does not have a constant $g_m$ over a rail-to-rail CMIR, sense circuitry is included to ensure that the sum of the $g_m$'s from these two differential pairs is constant over a rail-to-rail CMIR. The sense circuitry senses when one of the differential pairs is operating in a common mode input voltage range which does not have a constant $g_m$ and adjusts the current through the other differential pair to compensate. This feedback ensures that the total $g_m$ of the input stage remains nearly constant.

The sense circuitry consists of at least one pair of NMOS, or one pair of PMOS transistors with their gates connected to the two differential inputs, respectively to sense the common mode input voltage. When the common mode input voltage is not near either of the supply rails, this pair of transistors diverts a portion of the tail current away from the differential pair of the opposite type. When the common mode input voltage approaches the appropriate supply rail, these sense transistors, as well as the differential pair of the same type, begin to shut off. This reduces the amount of tail current diverted from the differential pair of the opposite type. Since less current is being diverted, more tail current is allowed to flow through the differential pair. This raises the $g_m$ of the differential pair an amount roughly equal to the loss in $g_m$ suffered by the differential pair that is of the same type as the sense transistors. Thus, the sum of the $g_m$'s

of both differential pairs is kept almost constant.

## BRIEF DESCRIPTION OF THE DRAWINGS

FIG. 1 is a schematic illustration of a constant transconductance input stage with one pair of NMOS sense transistors.

FIG. 2 is a schematic illustration of a constant transconductance input stage with one pair of NMOS sense transistors and one pair of PMOS sense transistors.

## DETAILED DESCRIPTION OF THE PREFERRED EMBODIMENTS

Fig. 1 is a schematic illustration of a constant transconductance input stage which uses only one pair of sense transistors. The input stage is shown generally by **100**. The input stage **100** is comprised of a NMOS differential pair **102** and a PMOS differential pair **104**. The tail current of the NMOS differential pair **102** is set by current source **108**. The tail current of the PMOS differential pair **104** is set by current source **110** minus the current through NMOS sense transistors **106**. NMOS differential pair **102** consists of NMOS transistors **114** and **116** whose sources are connected to node NSRC. Node NSRC is also connected to one side of current source **108**. The gates of NMOS transistors **114** and **116** are connected to input nodes INN and INP, respectively. The drain current through transistors **114** and **116** are labeled IONN and IONP, respectively. Currents IONN and IONP are two of the four output currents produced by input stage **100**.

PMOS differential pair **104** consists of PMOS transistors **118** and **120** whose sources are connected to node PSRC. Node PSRC is also connected to one side of current source **110**. The gates of PMOS transistors **118** and **120** are connected to input nodes INN and INP, respectively. The drain current through transistors **118** and **120** are labeled IOPN and IOPP, respectively. Currents IOPP and IOPN are the remaining two of the four output currents produced by input stage **100**.

Also connected to node PSRC are a pair of NMOS sense transistors **106**. Individually, the sense transistors are labeled **122** and **124**. The drains of NMOS transistors **122** and **124** are connected to node PSRC. The sources of NMOS transistors **122** and **124** are connected to node N1. One side of current source **112** is also connected to node N1. The gates of NMOS transistors **122** and **124** are connected to input nodes INN and INP, respectively. Transistors **122** and **124** may be chosen to have the same gain as transistors **118** and **120**.

Current source **108** is connected between node NSRC and the negative supply rail. Current source **110** is connected between the positive supply rail and node PSRC. Current source **112** is connected between node N1 and the negative supply rail. There are many possible implementations of current sources in a CMOS process which are well known in the art. One example circuit which may be used as a current source is a current mirror. Current sources **108**, **110**, and **112** may be implemented by any of these means. Because these are not ideal current sources, they are subject to turning off when no current path exists which can conduct the current they are programmed to conduct. For example, when both transistors **122** and **124** are off, current source **112** must also turn off.

The four outputs of the input stage are currents IONP, IONN, IOPP, and IOPN. These currents are summed by the next stage of the op-amp to produce an output. Output stages which sum four currents provided by an input stage are known in the art and input stage **100** may be combined with many of them to produce a complete op-amp.

Because the four output currents are summed, the $g_m$ of the input stage is the sum of the $g_m$'s from each individual differential pair **102** and **104**. When the MOS transistors of a differential pair are in saturation with a tail current of I, the $g_m$ of a differential pair is given by:

$$g_m = \sqrt{2K*I} \qquad (1)$$

K is a constant expressed as:

$$K = \frac{\mu_s C_{ox}}{2}\left(\frac{W}{L}\right) \qquad (2)$$

Where $C_{ox}$ is the capacitance per unit area of the gate region, μ, is the carrier mobility in the conducting channel, and W/L is the width-to-length, or aspect ratio of the channel region. Since K is constant for a given design, process, and type of transistor, the $g_m$ of a differential pair is dependant solely on the tail current. Note that K may be related to another constant $k$ by the equation $K=k/2$. The constant $k$ is known as the device transconductance parameter. The device transconductance parameter may also be expressed as:

$$k=\mu_s C_{ox}\left(\frac{W}{L}\right) \quad (3)$$

When the common mode voltage of inputs INP and INN is near the positive supply rail, differential pair **104** is off and the $g_m$ of the input stage **100** is given by:

$$g_m=\sqrt{2K_n*I} \quad (4)$$

where $K_n$ is the constant K, above, for differential pair **102**. When the common mode voltage of inputs INP and INN is near the negative supply rail, differential pair **102** and sense transistors **106** are both off. Because sense transistors **106** are off, all of the current from current source **110** flows through differential pair **104** as the tail current. In this region, the $g_m$ of the input stage **100** is given by:

$$g_m=\sqrt{2K_p*C*I} \quad (5)$$

where $K_p$ is the constant K, above, for the differential pair **104**. C is a constant which relates the current through current source **108** to the current through current source **110**. Since $K_p$ and $K_n$ are both constant and determined by design, they may be related by the equation $K_p=\alpha K_n$. Because the $g_m$ must be constant from rail-to-rail, the $g_m$ at these two points must be equal. Accordingly, to equalize $g_m$ at these two points:

$$C=\frac{1}{\alpha} \quad (6)$$

When the common mode input voltage is not near either supply rail, all of the transistors in input stage **100** are on, but not necessarily carrying a current. By picking the current through current source **112** to be C*I, all of the current from current source **110** will flow through sense transistors **106**. This leaves no current flowing through differential pair **104**. With no current flowing through differential pair **104**, it does not contribute to the overall $g_m$ of the input stage. Accordingly, the $g_m$ for the input stage in this region of operation is given by equation 4.

In summary, when the common mode input voltage is far away from the negative supply rail, differential pairs **104** and **102**, and sense transistors **106** are both on. However, because sense transistors **106** are on, current source **112** is able to conduct C*I current. This effectively diverts all of the current from current source **110** through sense transistors **106** and current source **112** to the negative supply. Therefore, there is no current coming out of current source **110** left to flow through differential pair **104** so the tail current of differential pair **104** is zero. Since the tail current of differential pair **104** is zero, it does not contribute to the overall $g_m$ of the input stage.

When the common mode input voltage is near the negative supply rail, sense transistors **106** turn off. This prevents current from flowing through sense transistors **106** which causes current source **112** to turn off. With no current flowing through sense transistors **106**, all of the current from current source **112** must flow through differential pair **104**. This gives differential pair **104** the tail current necessary to make up for the gain lost when differential pair **102** turned off

Fig. 2 is a schematic illustration of a constant transconductance input stage which uses two pairs of sense transistors. The input stage is shown generally by **200**. The input stage **200** is comprised of a NMOS differential pair **202** and

a PMOS differential pair **204**. The tail current of the NMOS differential pair **202** is set by current source **208** minus the current through PMOS sense transistors **280**. The tail current of the PMOS differential pair **204** is set by current source **210** minus the current through NMOS sense transistors **206**. NMOS differential pair **202** consists of NMOS transistors **214** and **216** whose sources are connected to node NSRC. Node NSRC is also connected to one side of current source **208**. The gates of NMOS transistors **214** and **216** are connected to input nodes INN and INP, respectively. The drain current through transistors **214** and **216** are labeled IONN and IONP, respectively. Currents IONN and IONP are two of the four output currents produced by input stage **200**.

Also connected to node NSRC are a pair of PMOS sense transistors **280**. Individually, the sense transistors are labeled **282** and **284**. The drains of PMOS transistors **282** and **284** are connected to node NSRC. The sources of PMOS transistors **282** and **284** are connected to node P1. One side of current source **286** is also connected to node P1. The gates of PMOS transistors **282** and **284** are connected to input nodes INN and INP, respectively.

PMOS differential pair **204** consists of MOS transistors **218** and **220** whose sources are connected to node PSRC. Node PSRC is also connected to one side of current source **210**. The gates of PMOS transistors **218** and **220** are connected to input nodes INN and INP, respectively. The drain current through transistors **218** and **220** are labeled IOPN and IOPP, respectively. Currents IOPP and IOPN are the remaining two of the four output currents produced by input stage **200**.

Also connected to node PSRC are a pair of NMOS sense transistors **206**. Individually, the sense transistors are labeled **222** and **224**. The drains of NMOS transistors **222** and **224** are connected to node PSRC. The sources of NMOS transistors **222** and **224** are connected to node N1. One side of current source **212** is also connected to node N1. The gates of NMOS transistors **222** and **224** are connected to input nodes INN and INP, respectively.

Current source **208** is connected between node NSRC and the negative supply rail. Current source **210** is connected between the positive supply rail and node PSRC. Current source **212** is connected between node N1 and the negative supply rail. Current source **286** is connected between the positive supply rail and node P1. There are many possible implementations of current sources in a CMOS process which are well known in the art. Current sources **208**, **210**, **212**, and **286** may be implemented by any of these means. Because these are not ideal current sources, they are subject to turning off when no current path exists which can conduct the current they are programmed to conduct. For example, when both transistors **282** and **284** are off, current source **286** must also turn off.

The four outputs of the input stage are currents IONP, IONN, IOPP, and IOPN. These currents are summed by the next stage of the op-amp to produce an output. Output stages which sum four currents provided by an input stage are known in the art and input stage **200** may be combined with many of them to produce a complete op-amp.

Since the current though current sources **208**, **286**, **210**, and **212** are all constant, they may be related as multiples of each other. If the current through current source **208** is I, the current through current sources **286**, **210**, and **212** may be related as B*I, C*I, and D*I, respectively. By equalizing the $g_m$ when differential pair **202** is off and when differential pair **204** is off, equation 6 is once again derived and $C=1/\alpha$. By equalizing the $g_m$ when either differential pair **202** or **204** is off, to the case when both differential pairs **202** and **204** and both sets of sense transistors **206** and **280** are on, the following equation may be derived:

$$D=\frac{B-1+2\sqrt{1-B}}{\alpha} \qquad (7)$$

Note that when B=0, $D=1/\alpha$. This case is equivalent to the circuit in FIG. 1. Also note that when B=1, D=0. This case is equivalent to removing NMOS sense transistors **206**.

Accordingly, this invention may be implemented with a single pair of NMOS sense transistors, a single pair of PMOS sense transistors, or two pairs of sense transistors, one pair NMOS and one pair PMOS.

For the purposes of explaining the operation of the circuit in FIG. 2, assume that the circuit has been designed such that $\alpha=1$, or alternatively, $K_p=K_n=K_x$. Plugging $\alpha=1$ into equation 6, the result is C=1. Further assume that B=.75 which gives us D=.75 from equation 7. When the common mode input voltage is near a supply rail so that one differential pair and one set of sense transistors is off, we get:

$$g_m=\sqrt{2K_xI} \qquad (8)$$

When the common mode input voltage is not near a supply rail, both differential pairs **202** and **204** are on and both pairs

of sense transistors **206** and **280** are on. In this case:

$$g_m=\sqrt{2K_x(I-.75I)}+\sqrt{2K_x(I-.75I)}=2\sqrt{.5K_xI}=\sqrt{2K_xI} \quad (9)$$

Note that this is the same $g_m$ as calculated in equation 8.

Using these numbers, the operation of the input stage can be explained as follows: When the common mode input voltage is near the negative supply voltage, the NMOS differential pair **202** is off so it contributes nothing to the overall $g_m$ of the circuit. To make up for that loss of $g_m$, more current is channeled through the PMOS differential pair **204** to increase its contribution to the overall $g_m$. This is accomplished with a pair of NMOS sense transistors **206** which turn off whenever differential pair **202** turns off. When NMOS sense transistors **206** turn off, it forces the current which would otherwise have traveled through those transistors to flow through PMOS differential pair **204**. The current which flows through NMOS sense transistors **206** when they are on is set by current source **212** and is chosen to match the amount of current required to boost the $g_m$ of PMOS differential pair **204** by the amount of overall $g_m$ lost when NMOS differential pair **202** is off.

Likewise, when the common mode input voltage is near the positive supply voltage, the PMOS differential pair **204** is off so it contributes nothing to the overall $g_m$ of the circuit. To make up for that loss $g_m$, more current is channeled through the NMOS differential pair **202** to increase its contribution to the overall $g_m$. This is accomplished with a pair of PMOS sense transistors **280** which turn off whenever differential pair **204** turns off. When PMOS sense transistors **280** turn off, it forces the current which would otherwise have traveled through those transistors to flow through NMOS differential pair **202**. The current which flows through PMOS sense transistors **280** when they are on is set by current source **286** and is chosen to match the amount of current required to boost the $g_m$ of NMOS differential pair **202** by the amount of overall $g_m$ lost when PMOS differential pair **204** is off

When the common mode input voltage is not near either supply voltage, both differential pairs **202** and **204** are contributing to the overall $g_m$. Therefore, the amount of current supplied by current sources **208** and **210** is chosen to supply all of the current flowing through sense transistors **280** and **206**, respectively, plus amounts which supply differential pairs **202** and **204**, respectively, with enough respective current that the sum of the $g_m$'s of differential pairs **202** and **204** equals an overall $g_m$ equivalent to the overall $g_m$ described above when only one differential pair is operating.

The aspect ratio of the sense transistors **280** and **206** may be chosen so that they have a gain which is equal to differential pairs **202** and **204**, respectively. Alternatively, the aspect ratio of the sense transistors **280** and **206** may be chosen to minimize the variations in $g_m$ when the common mode input voltage is in the transition regions between having only one differential pair operating and two differential pairs operating. Once the other circuit parameters are chosen, simulation and/or trial and error may be used to choose the sizes of the pairs of sense transistors **280** and **206** which minimize variation of $g_m$ in the transition regions.

It is to be understood that the claimed invention is not to be limited by the preferred embodiments but encompasses other modifications and alterations within the scope and spirit of the inventive concept. For example, the NMOS and PMOS transistors may be replaced by NPN and PNP bipolar transistors, respectively.

## Claims

1. An amplifier input stage, comprising:

   a pair of differential inputs (INN, INP);

   a NMOS differential pair (102), said NMOS differential pair being coupled to said pair of differential inputs;

   a PMOS differential pair (104), said PMOS differential pair being coupled to said pair of differential inputs, said PMOS differential pair also having a first PMOS tail current; and

   a pair of NMOS sense transistors(106), said pair of NMOS sense transistors being coupled to said pair of differential inputs, said pair of NMOS sense transistors conducting a NMOS sense current which reduces said first PMOS tail current to a second PMOS tail current when said pair of NMOS sense transistors are conducting.

2. The amplifier input stage of claim 1, wherein said NMOS sense current is substantially equal to said first PMOS tail current.

3. The amplifier input stage of claim 2, wherein said NMOS differential pair (102) has a NMOS tail current, and wherein said PMOS differential pair (104) is comprised of two PMOS transistors (118, 120) each with a PMOS device transconductance parameter, and wherein said NMOS differential pair (102) is comprised of two NMOS transistors (114, 116) each with a NMOS device transconductance parameter, and said first PMOS tail current multiplied by said PMOS device transconductance parameter is substantially equal to said NMOS tail current multiplied by said NMOS device transconductance parameter.

4. An amplifier input stage, comprising:

a pair of differential inputs;
a PMOS differential pair, said PMOS differential pair being coupled to said pair of differential inputs;
a NMOS differential pair, said NMOS differential pair being coupled to said pair of differential inputs, said NMOS differential pair also having a first NMOS tail current; and
a pair of PMOS sense transistors, said pair of PMOS sense transistors being coupled to said pair of differential inputs, said pair of PMOS sense transistors conducting a PMOS sense current which reduces said first NMOS tail current to a second NMOS tail current when said pair of PMOS sense transistors are conducting.

5. The amplifier input stage of claim 4, wherein said PMOS sense current is substantially equal to said first NMOS tail current.

6. The amplifier input stage of claim 5, wherein said PMOS differential pair has a PMOS tail current, and wherein said NMOS differential pair is comprised of two NMOS transistors each with a NMOS device transconductance parameter, and wherein said PMOS differential pair is comprised of two PMOS transistors each with a PMOS device transconductance parameter, and said first NMOS tail current multiplied by said NMOS device transconductance parameter is substantially equal to said PMOS tail current multiplied by said PMOS device transconductance parameter.

7. An amplifier input stage, comprising:

a pair of differential inputs (INN, INP);
a NMOS differential pair (202), said NMOS differential pair being coupled to said pair of differential inputs, said NMOS differential pair also having a first NMOS tail current, and a second NMOS tail current;
a PMOS differential pair (204), said PMOS differential pair being coupled to said pair of differential inputs, said PMOS differential pair also having a first PMOS tail current and a second PMOS tail current;
a pair of NMOS sense transistors (206), said pair of NMOS sense transistors being coupled to said pair of differential inputs, said pair of NMOS sense transistors conducting a NMOS sense current which reduces said first PMOS tail current to said second PMOS tail current when said pair of NMOS sense transistors are conducting; and
a pair of PMOS sense transistors (280), said pair of PMOS sense transistors being coupled to said pair of differential inputs, said pair of PMOS sense transistors conducting a PMOS sense current which reduces said first NMOS tail current to said second NMOS tail current when said pair of PMOS sense transistors are conducting.

8. The amplifier input stage of claim 7, wherein said PMOS differential pair (204) is comprised of two PMOS transistors (218, 220) each with a PMOS device transconductance parameter, and wherein said NMOS differential pair is comprised of two NMOS transistors (214, 216) each with a NMOS device transconductance parameter, and said first PMOS tail current multiplied by said PMOS device transconductance parameter is substantially equal to said first NMOS tail current multiplied by said NMOS device transconductance parameter.

9. The amplifier input stage of claim 7, wherein $\alpha$, B, C, and D are constants, and wherein said PMOS differential pair (204) is comprised of two PMOS transistors (218, 220) each with a PMOS device transconductance parameter, and wherein said NMOS differential pair (202) is comprised of two NMOS transistors (214, 216) each with a NMOS device transconductance parameter, and wherein said first NMOS tail current equals I, said PMOS sense current equals B*I, said first PMOS tail current equals C*I, and said NMOS sense current equals D*I, said constant $\alpha$ being substantially equal to said PMOS device transconductance parameter divided by said NMOS device transconductance parameter, said constant C being substantially equal to $1/\alpha$, and said constant D being substantially related to said constant B by the equation

$$D=\frac{B-1+2\sqrt{1-B}}{\alpha}$$

where $0 \leq B \leq 1$.

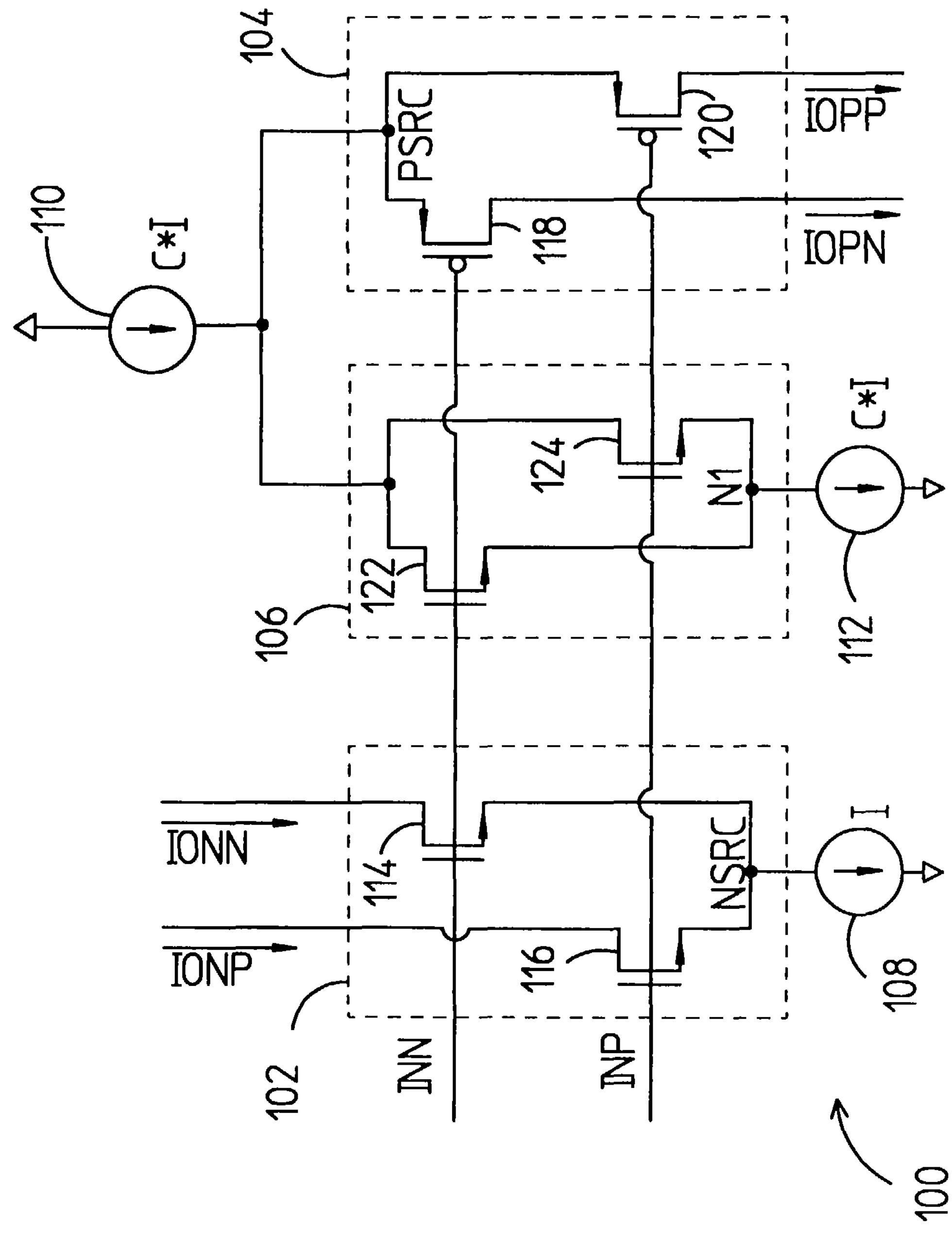
104
110
C*I
PSRC
120
118
IOPP
IOPN
106
124
122
N1
C*I
112
IONN
IONP
114
116
NSRC
I
108
102
INN
INP
100

FIGURE 1

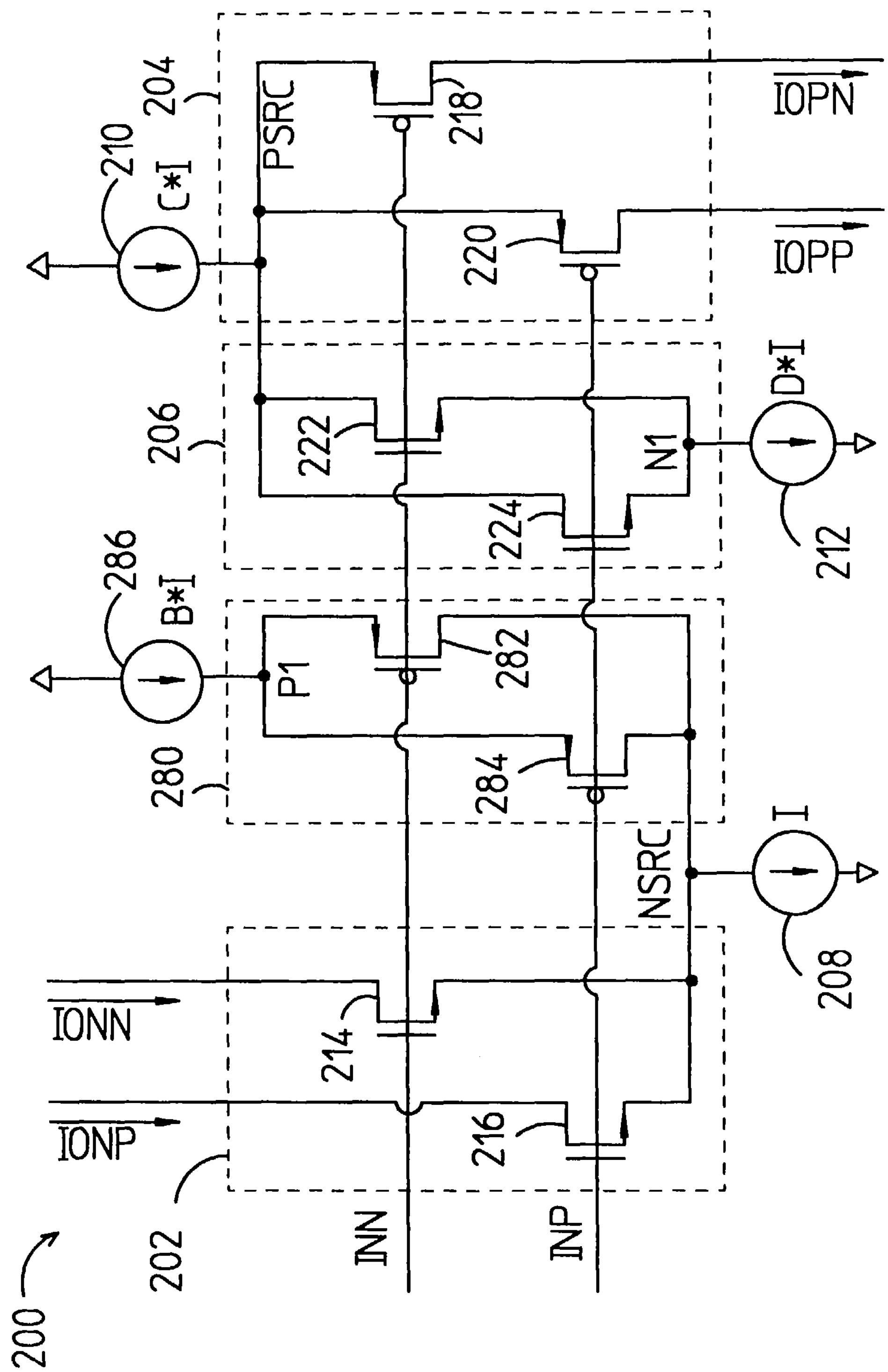
200
202
204
206
280
210
C*I
286
B*I
D*I
212
I
208
PSRC
NSRC
P1
N1
214
216
218
220
222
224
282
284
IONN
IONP
IOPN
IOPP
INN
INP

FIGURE 2

European Patent Office

# EUROPEAN SEARCH REPORT

Application Number
EP 97 10 9138

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X<br>A | US 5 384 548 A (SAKURAI SATOSHI ET AL)<br>* the whole document * | 1-6<br>7-9 | H03F3/45 |
| A | EP 0 499 554 A (SGS THOMSON MICROELECTRONICS)<br>* column 4, line 31 - column 7, line 26; figure 2 * | 7-9 | |
| A | EP 0 606 144 A (SGS THOMSON MICROELECTRONICS)<br>* page 3, line 29 - line 55; figure 5 * | 7-9 | |
| | | | TECHNICAL FIELDS SEARCHED (Int.Cl.6) |
| | | | H03F |

The present search report has been drawn up for all claims

| Place of search | Date of completion of the search | Examiner |
|---|---|---|
| THE HAGUE | 9 January 1998 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)